# FASCICULE DE BREVET EUROPEEN

(11) **EP 2 777 060 B1**
(45) Date de publication et mention de la délivrance du brevet: **13.01.2016**
(21) Numéro de dépôt: 12784235.9
(22) Date de dépôt: 06.11.2012
(51) Int. Cl.: H01J 37/16, H01J 37/18

(54) **DISPOSITIF BLINDE DE MICROSCOPE ELECTRONIQUE A BALAYAGE**
GEPANZERTE VORRICHTUNG FÜR ELEKTRONISCHES RASTERMIKROSKOP
ARMORED DEVICE FOR ELECTRONIC SCANNING MICROSCOPE

(30) Priorité: 09.11.2011 FR 1160216
(43) Date de publication de la demande: 17.09.2014
(73) Titulaire: Commissariat à l'Énergie Atomique et aux Énergies Alternatives, 75015 Paris (FR)
(72) Inventeur: LEORIER, Caroline, F-30133 Les Angles (FR); CARON, Serge, F-30130 Pont Saint Esprit (FR); COURROYE, Daniel, F-84700 Sorgues (FR); BRENNEIS, Christophe, F-30290 Saint Victor La Coste (FR); WIDEHEM, Michel, F-40131 Pujaut (FR); PLATON, Raphaël, F-30190 Sainte Anastasie (FR); RIGOTARD-BARBADORO, Jean-Paul, F-84350 Courthezon (FR); DUBUC, Fabrice, F-30760 Saint Julien De Peyrolas (FR); CHALAL, Smail, F-26120 Montmeyran (FR)
(74) Mandataire: Ilgart, Jean-Christophe
(86) Numéro de dépôt international: PCT/EP2012/071870
(87) Numéro de publication internationale: WO 2013/068321

(56) Documents cités:
- WO-A1-00/08450
- US-A- 5 139 383
- US-A- 5 508 518
- US-A1- 2002 028 399

## Description

Le sujet de l'invention présente est un dispositif de microscope électronique à balayage, blindé puisque conçu spécialement pour des produits dangereux, en particulier irradiants, qui ne permettent pas l'introduction directe des échantillons dans le microscope.

Il faut procéder à travers une enceinte de protection qui constitue le blindage. Les échantillons y sont généralement introduits en étant enfermés dans des récipients de protection étanches. Les récipients sont ouverts après avoir été introduits dans l'enceinte, et les échantillons peuvent alors être introduits dans la chambre d'examen du microscope.

Les microscopes sont en général entièrement plongés dans l'enceinte, et les observations se font par l'intermédiaire de dispositifs périphériques permettant la commande et l'observation. Cette conception est peu commode en l'absence d'accès direct à la plupart des éléments du microscope, et on observe une dégradation rapide de certains des éléments qui sont plongés dans l'enceinte, notamment les composants électroniques à cause de l'atmosphère particulière dans laquelle ils baignent en général. Un inconvénient encore plus important est la diminution des performances du microscope même quand il est en bon état : les enceintes de protection doivent être maintenues en dépression pour interdire des disséminations accidentelles de matières dangereuses vers l'extérieur ; l'entretien de cette dépression produit des vibrations qui sont communiquées au microscope en rendant ses images floues. Un meilleur dispositif de microscope électronique à balayage blindé a donc été recherché.

L'idée à la base de l'invention est de placer la plupart du microscope électronique hors de l'enceinte de protection, qui devient un simple lieu de transfert entre l'extérieur et la chambre d'examen. Cette dernière est reliée à l'enceinte par une jonction souple, et qui filtre donc la plus grande partie des vibrations dont l'enceinte est le siège. Le microscope étant plongé dans l'atmosphère normale, les vibrations ne lui sont plus communiquées par ses surfaces extérieures. Une porte est disposée à la jonction entre l'enceinte et la chambre d'examen, afin d'isoler celle-ci ou au contraire de permettre les transferts d'échantillons.

La portion souple de la jonction est avantageusement à soufflet.

Il est encore avantageux que la chambre d'examen puisse être détachée de l'enceinte, par exemple pour permettre de l'entretien ou des réparations. On peut alors envisager favorablement que la portion souple de la jonction soit jointe à une interface côté compartiment, qui est assemblée de façon séparable à une interface côté enceinte ; ces interfaces peuvent être des plaques accolées recevant la porte quand elle opère la fermeture.

Cette construction peut être perfectionnée si la porte est alors composée de deux portions superposées pouvant être assemblées l'une à l'autre ou séparées au choix, lesdites portions de porte étant aptes à clore respectivement les interfaces : elles restent en général assemblées entre elles, sauf pendant les séparations de l'enceinte et de la chambre d'examen, où elles demeurent alors respectivement sur les interfaces et sont détachées l'une de l'autre, ce qui permet de maintenir la fermeture de la chambre d'examen et de l'enceinte. La porte peut être entièrement amovible de l'ouverture à la jonction entre l'enceinte et la chambre d'examen, et y être retenue par un joint périphérique logé dans cette jonction en saillant dans l'ouverture, ce joint pouvant être gonflable.

Un autre joint, situé à la périphérie des portions de porte, peut être prévu ; il est comprimé entre les portions de porte quand elles sont assemblées l'une à l'autre, ce qui évite toute entrée de matière polluante entre elles.

Selon une autre caractéristique possible et favorable de l'invention, le microscope et l'enceinte sont montés sur des supports séparés et l'enceinte est montée sur son support par des blocs amortissants : le découplage mécanique et l'absorption des vibrations avant qu'elles n'atteignent le microscope est alors meilleur.

Il est encore avantageux que l'enceinte forme un coude enveloppant partiellement la chambre d'examen et comprenne une portion latérale par une face antérieure de laquelle les échantillons sont introduits et retirés depuis et vers un environnement extérieur, et une portion postérieure comprenant la jonction à la chambre d'examen, l'enceinte comprenant encore des moyens de manipulation de l'échantillon par un opérateur présent devant la face antérieure : l'opérateur bénéficie d'un accès facile au dispositif, tout en pouvant placer l'échantillon dangereux à distance avant qu'il ne soit sorti de son récipient et transféré dans la chambre d'examen à l'aide d'un télémanipulateur.

Le dispositif peut alors être complété par une enveloppe extérieure de protection aux radiations

Ces aspects de l'invention ainsi que d'autres seront maintenant décrites en détail au moyen des figures suivantes, qui en illustrent une réalisation non exclusive :
- la Figure 1 illustre un microscope électronique à balayage,
- la Figure 2 représente l'enceinte de protection,
- la Figure 3 représente le dispositif globalement,
- la Figure 4 représente l'arrière du dispositif et surtout la jonction entre les microscopes et l'enceinte,
- la Figure 5 représente la porte de séparation,
- la Figure 6 représente les détails de la jonction,
- et les Figures 7 et 8 représentent les modes de fermeture de l'enceinte et du microscope quand ils sont réparés.

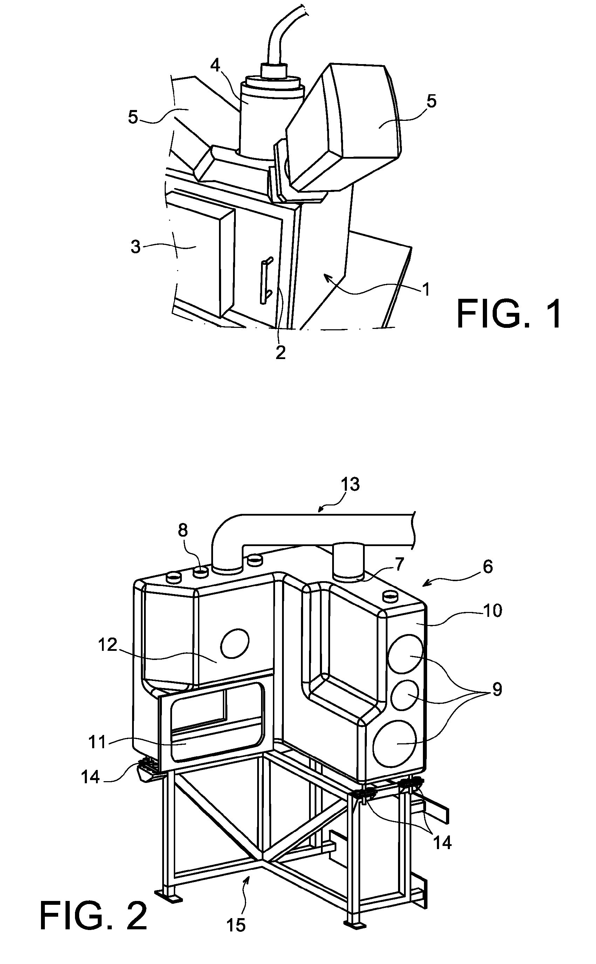

Un microscope à balayage comprend, comme on le représente à la Figure 1 : une chambre d'examen (1) dans laquelle les échantillons à étudier sont placés, et qui comprend une couverture (2) de laquelle un tiroir (3), dans lequel les échantillons sont posés, peut être sorti, le tiroir (3) closant l'ouverture (2) quand il est refermé en saillant seulement légèrement d'elle ; une colonne (4) surplombant la chambre d'examen (1), dans laquelle le faisceau électronique est formé, accéléré et dirigé vers l'échantillon ; et des satellites analytiques (5) en nombre variable et surplombant également la chambre d'examen (1) ; ils sont responsables des mesures et analyses et dépendent donc des expériences effectuées.

L'invention implique l'emploi d'une enceinte (6) particulière utilisée conjointement au microscope et dont la description générale sera donnée à propos de la Figure (2). Elle est de forme coudée et composée d'une aile latérale (7) et d'une aile postérieure (8). L'aile latérale (7) comprend des ouvertures (9) à une face antérieure (10), qui sont affectées à l'introduction et l'enlèvement des échantillons ainsi qu'à leur manipulation dans l'enceinte (6) ; elles sont pourvues de gants souples de manipulation, d'un système de préhension et de manchons souples pour acceillir un conteneur de type produit par la société La Calhène permettant l'introduction ou le retrait d'échantillons. L'aile postérieure (8) comprend une ouverture de grande taille (11) à sa face antérieure (12), qui est destinée à être abouchée à l'ouverture (2) de la chambre d'examen (1) du microscope. L'enceinte (6) correspond à une boîte à gant close en service et dans laquelle une dépression est alors instaurée par des conduits d'aspiration extérieurs (13). Des blocs amortissants (14) permettent de la poser sur un support (15) également coudé.

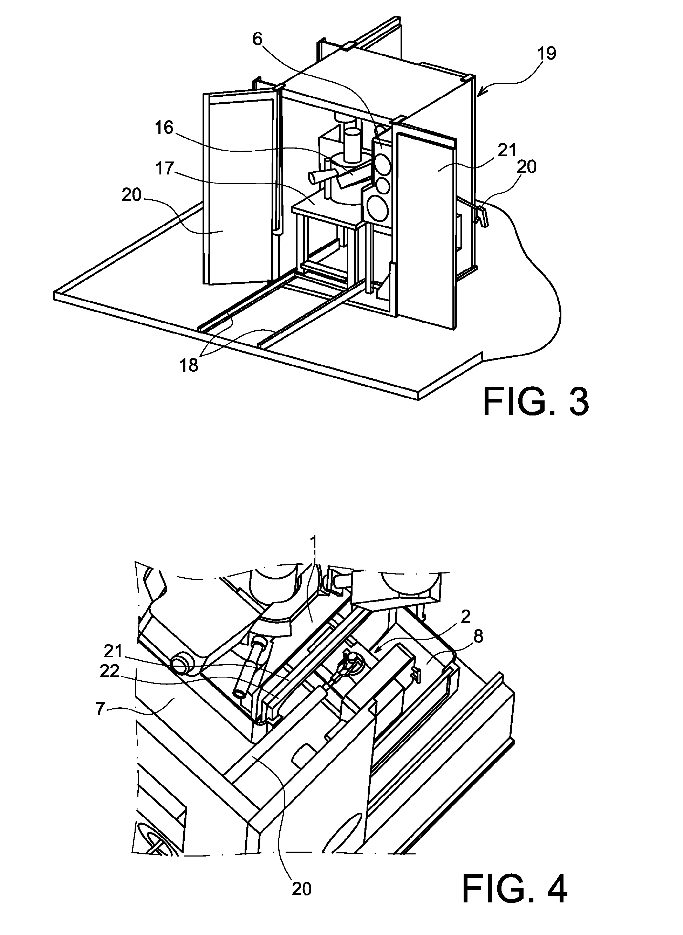

L'ensemble du dispositif est représenté à la Figure 3 dans la position normale, le microscope (16) étant placé dans le creux de l'enceinte (6), à la même hauteur et adjacent à elle, mais sans autre liaison que celle qu'on va bientôt décrire ; en particulier, il est monté sur son support (17) qui roule sur des rails (18) lesquels permettent d'avancer le microscope (16) pour modifier par exemple l'agencement des satellites (5) ou le réparer. Une enveloppe de protection biologique (19), utile pour protéger d'échantillons irradiants, entoure l'enceinte (6) et le microscope (16), mais sa face antérieure est ouvrante et comprend deux battants (40 et 41) permettant de dégager le microscope (16) et la table (17), ou la face antérieure (10) de l'aile latérale (7) de l'enceinte (6).

La Figure 4 illustre que les faces latérales de l'enveloppe de protection biologique (19) et de l'aile latérale (7) de l'enceinte (6) peuvent être traversées par un télémanipulateur (20) d'un genre connu qui s'enfonce dans l'aile postérieure (8) de l'enceinte (6). Il est affecté aux manipulations des échantillons radioactifs. Les échantillons peuvent être sortis de leurs récipients de protection, déplacés, et posés sur le tiroir (2), auparavant sorti de la chambre d'examen (1) et pénétrant dans l'aile postérieure (8).

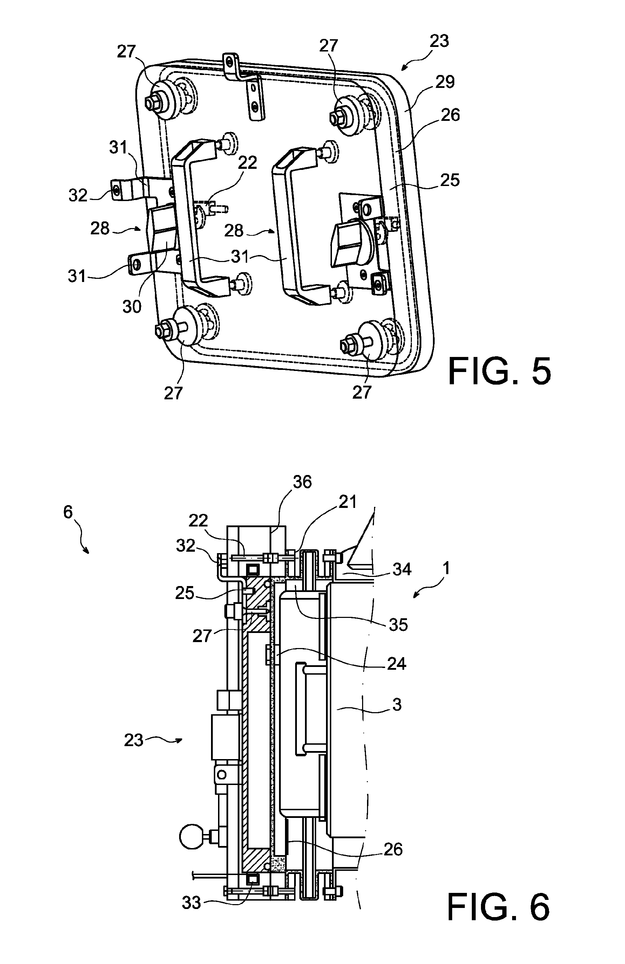

L'ouverture (2) est délimitée par une interface (21) en forme de plaque, et l'ouverture (11) par une autre interface (22) également en forme de plaque, les interfaces (21 et 22) étant boulonnées entre elles mais pouvant être démontées l'une de l'autre et séparées quand le microscope (16) doit être déplacé. Une porte (23), représentée isolément à la Figure 5, complète le dispositif. Elle peut être placée de manière à clore l'ouverture (2 et 11) composite formés par les interfaces (21 et 22) ou être dégagée d'elle et placée de côté dans l'aile postérieure (8). Elle comprend deux portions (24 et 25) respectivement associées aux interfaces (21 et 22), superposées, un joint périphérique (26) étant comprimé entre elles de manière à isoler le volume intermédiaire des pollutions ; les portions (24 et 25) sont unies entre elles par des broches (27) de mise en correspondance solidaires de la portion (25) et qui pénètrent dans des perçages de la portion (24), et par des verrous (28) dont les pênes (29), solidaires de la portion (24), peuvent être placés dans des logements de la portion (25) ; cette dernière comprend des boutons (30) engrenant avec les pênes (29) pour les déplacer, ainsi que des poignées de manipulation (31) et des butées latérales (32) servant au guidage de la porte dans l'ouverture composite (2 et 11) et dont certaines comprennent un rebord courbé (32) limitant l'enfoncement.

La Figure 6 illustre le dispositif quand la porte (23) est placée sur l'ouverture composite (2 et 11) : les rebords courbés (32) touchent l'interface (22) côté enceinte (6), la portion (25) est disposée dans cette interface (22) et l'autre portion (24) est enfoncée dans l'interface (21) côté microscope, de manière à les obturer. La porte (23) est maintenue en place par le gonflage d'un joint périphérique (33) qui est logé dans une rainure circulaire de l'interface (22) associée à l'enceinte (6), et qui est apte à saillir fortement vers l'extérieur quand il est gonflé, de manière à enserrer la portion (25).

Un détail important de l'invention est que l'interface (21) est jointe à l'enveloppe (34) de la chambre d'examen (1) par un soufflet (35) souple, dans lequel la partie externe du tiroir (3) est contenue. L'effet fondamental du soufflet (35) est de produire un découplage entre l'enceinte (6) et la chambre d'examen (1) (ou le microscope (16) en général) en ce qui concerne les vibrations, sans compromettre l'étanchéité de la jonction. Quand la porte (23) est placée, le joint (33) contribue à séparer complètement les volumes de la chambre d'examen (1) et de l'enceinte (6). Un joint supplémentaire, non représenté, peut être prévu entre la portion (24) et l'interface (21) du côté de la chambre d'examen (1).

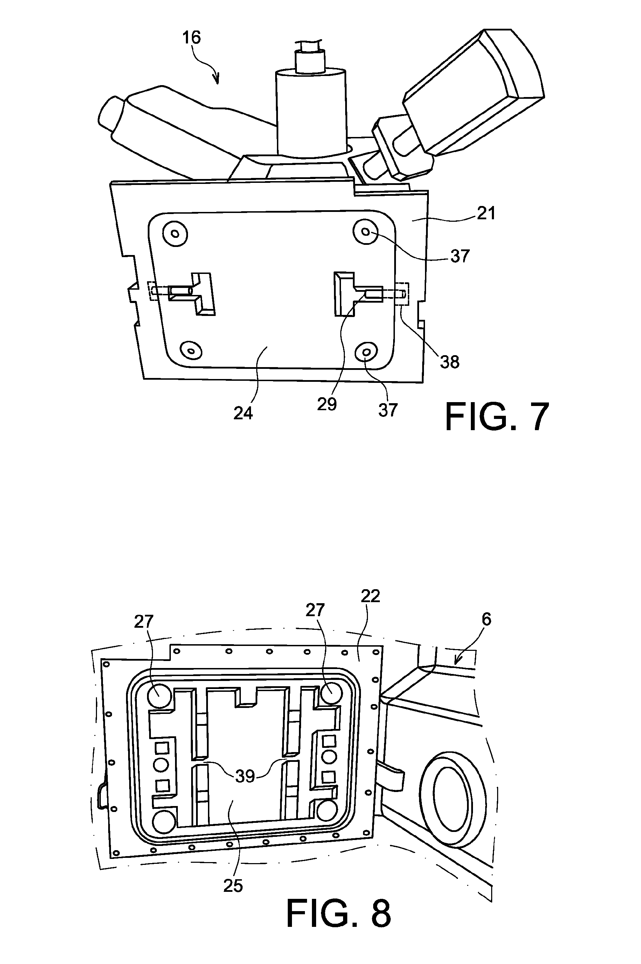

Les interfaces (21 et 22) sont unies par des vis (36). L'enceinte (6) et le microscope (16) peuvent être séparés quand les vis (36) sont démontées, et l'interface prend l'aspect donné par les Figures 7 et 8 si la porte est installée (ce qui est normal alors) et que les portions (24 et 25) sont elles aussi séparées. La Figure 7 montre les perçages (37) de réception des broches (27). Une rotation des boutons (30) a dégagé les pênes (29) des logements (39) situés sous la portion (25), de manière à pénétrer dans d'autres logements (38) établis dans l'interface (21), et y maintenir solidement la portion (24) ; la portion (25) reste retenue dans l'interface (22) du côté de l'enceinte (6) par le gonflage du joint périphérique (33).

On exposera brièvement les opérations accomplies sur ce dispositif. Quand un échantillon doit être placé dans le microscope (16), le battant (41) de la protection biologique (19) est ouvert, et l'échantillon est introduit dans l'enceinte (6). Le tiroir (2) est tiré vers l'arrière. Le manipulateur (20) sort l'échantillon de son récipient, le place sur le tiroir (2), repousse le tiroir (2) dans la chambre d'examen (1). La porte (23) précédemment rangée dans l'aile postérieure (8) peut être replacée dans l'ouverture composite (2 et 11) en cas de fortes perturbations dues à des vibrations. Le joint périphérique (33) est gonflé. L'opérateur peut refermer le battant (21), et les mesures commencent. L'échantillon est sorti du dispositif par des opérations inverses.

Pour des opérations de maintenance, au cas où le microscope (16) doit être sorti du dispositif, la porte est mise en place, le joint périphérique est gonflé et les portions séparées. Ainsi les vis (36) sont démontées et les boutons (30) tournés de manière à séparer les portions de porte (24 et 25). Le microscope (16) est alors complètement détaché de l'enceinte (6) et peut être tiré hors de l'enceinte de protection biologique (19). L'intervalle entre les portions de porte (24 et 25), n'étant pas exposé à l'atmosphère polluée de l'enceinte (6), n'est pas pollué lui-même. L'étanchéité et le confinement restent assurés par le joint périphérique (33). Le remontage s'effectue par des opérations inverses.

Il a été confirmé que l'invention offrait des vues presque aussi nettes qu'en l'absence de l'enceinte (6), ce qui montre que les vibrations originaires de celle-ci sont bien filtrées par la jonction au soufflet (35). Une bonne protection des opérateurs et des observateurs est maintenue.

## Revendications

1. Dispositif de microscope à balayage électronique, comprenant une enceinte (6) d'introduction d'échantillons dans une chambre (1) du microscope, l'enceinte étant soumise à une dépression, **caractérisé en ce que** le microscope (16) s'étend hors de l'enceinte et l'enceinte est abouchée à la chambre par une jonction comprenant une porte (23) de séparation entre la chambre et l'enceinte, la porte pouvant être ouverte, et une portion souple et étanche (35) sépare la chambre de l'enceinte.

2. Dispositif de microscope suivant la revendication 1, **caractérisé en ce que** la portion souple de la jonction est un soufflet.

3. Dispositif de microscope suivant la revendication 1 ou 2, **caractérisé en ce que** la portion souple de la jonction est unie à une interface (21) côté chambre (22), qui est assemblée de façon séparable à une interface côté enceinte.

4. Dispositif de microscope suivant la revendication 3, **caractérisé en ce que** la porte (23) est composée de deux portions (24, 25) superposées pouvant être assemblées l'une à l'autre ou séparées, lesdites portions de porte (21, 22) étant aptes à clore respectivement les interfaces.

5. Dispositif de microscope suivant l'une quelconque des revendications 1 à 4, **caractérisé en ce que** la porte est amovible et retenue par un joint périphérique (33) logé dans la jonction et saillant dans une ouverture de la jonction.

6. Dispositif de microscope suivant la revendication 5, **caractérisé en ce que** le joint périphérique est gonflable.

7. Dispositif de microscope suivant la revendication 4, **caractérisé en ce qu'**un second joint périphérique (26) est comprimé entre les portions de porte quand elles sont assemblées l'une à l'autre.

8. Dispositif de microscope suivant la revendication 4 ou 7, **caractérisé en ce que** les portions de porte sont assemblées par des broches (27) de mise en correspondance et des verrous (28).

9. Dispositif de microscope suivant la revendication 8, **caractérisé en ce que** les verrous sont à double effet et retiennent aussi une des portions de porte (24) dans l'interface (21) côté chambre.

10. Dispositif de microscope suivant l'une quelconque des revendications précédentes, **caractérisé en ce que** le microscope (16) et l'enceinte (6) sont montés sur des supports séparés (15, 17), et l'enceinte (6) est montée sur son support par des blocs amortissants (14).

11. Dispositif de microscope suivant l'une quelconque des revendications précédentes, **caractérisé en ce que** l'enceinte (6) forme un coude enveloppant partiellement le compartiment du microscope, et comprend une aile latérale (7) par une face antérieure de laquelle les échantillons sont introduits et retirés depuis et vers un environnement extérieur et une aile postérieure (8) comprenant la jonction à la chambre.

12. Dispositif de microscope suivant la revendication 11, **caractérisé en ce qu'**il comprend une enveloppe extérieure de protection (19 ; 40, 41), s'ouvrant à volonté devant la face antérieure de l'enceinte et devant le microscope (16).

## Patentansprüche

1. Elektronische Rastermikroskopvorrichtung, umfassend ein Gehäuse (6) für die Einführung von Proben in eine Kammer (1) des Mikroskops, wobei das Gehäuse einer Vertiefung unterliegt, **dadurch gekennzeichnet, dass** das Mikroskop (16) aus dem Gehäuse herausragt und das Gehäuse mit der Kammer durch ein Verbindungselement verbunden ist, welches eine Abtrennung (23) zwischen der Kammer und dem Gehäuse aufweist, wobei die Abtrennung geöffnet werden kann, und wobei ein flexibler und dichter Abschnitt (35) die Kammer von dem Gehäuse trennt.

2. Mikroskopvorrichtung nach Anspruch 1, **dadurch gekennzeichnet, dass** der flexible Abschnitt der Verbindung ein Balg ist.

3. Mikroskopvorrichtung nach Anspruch 1 oder 2, **dadurch gekennzeichnet, dass** der flexible Abschnitt der Verbindung vereint ist mit einer Schnittstelle (21) auf der Seite der Kammer (22), die auf trennbare Weise mit einer Schnittstelle auf der Seite des Gehäuses montiert ist.

4. Mikroskopvorrichtung nach Anspruch 3, **dadurch gekennzeichnet, dass** sich die Abtrennung (23) aus zwei übereinander liegenden Abschnitten (24, 25) zusammensetzt, die aneinander oder getrennt montiert werden können, wobei die Abschnitte der Abtrennung (21, 22) jeweils die Schnittstellen abschließen können.

5. Mikroskopvorrichtung nach einem der Ansprüche 1 bis 4, **dadurch gekennzeichnet, dass** die Abtrennung entfernbar ist und durch eine Umfangsdichtung (33) gehalten ist, die in der Verbindung aufgenommen ist und in eine Öffnung der Verbindung ragt.

6. Mikroskopvorrichtung nach Anspruch 5, **dadurch gekennzeichnet, dass** die Umfangsdichtung aufblasbar ist.

7. Mikroskopvorrichtung nach Anspruch 4, **dadurch gekennzeichnet, dass** eine zweite Umfangsdichtung (26) zwischen den Abtrennungsabschnitten zusammengedrückt ist, wenn diese aneinander montiert sind.

8. Mikroskopvorrichtung nach Anspruch 4 oder 7, **dadurch gekennzeichnet, dass** die Abtrennungsabschnitte mit Stiften (27) zur Ausrichtung und mit Riegeln (28) montiert sind.

9. Mikroskopvorrichtung nach Anspruch 8, **dadurch gekennzeichnet, dass** die Riegel eine Doppelwirkung haben und auch einen der Abtrennungsabschnitte (24) in der Schnittstelle (21) auf der Kammerseite halten.

10. Mikroskopvorrichtung nach einem der vorangehenden Ansprüche, **dadurch gekennzeichnet, dass** das Mikroskop (16) und das Gehäuse (6) auf getrennten Trägern (15, 17) montiert sind und das Gehäuse (6) auf seinem Träger durch Blöcke aus dämpfendem Material (14) montiert ist.

11. Mikroskopvorrichtung nach einem der vorangehenden Ansprüche, **dadurch gekennzeichnet, dass** das Gehäuse (6) einen Bogen bildet, der den Bereich des Mikroskops teilweise umhüllt und einen Seitenflügel (7) umfasst, wobei die Proben durch eine Vorderseite desselben aus einer und in eine Außenumgebung eingeführt und entnommen werden, und einen Hinterflügel (8), der die Verbindung mit der Kammer umfasst.

12. Mikroskopvorrichtung nach Anspruch 11, **dadurch gekennzeichnet, dass** sie eine äußere Schutzhülle (19; 40, 51) aufweist, die sich bei Bedarf an der Vorderseite des Gehäuses und vor dem Mikroskop (16) öffnet.

## Claims

1. Electronic scanning microscope device, comprising a housing (6) for inserting samples into a chamber (1) of the microscope, the housing being subject to negative pressure, **characterised in that** the microscope (16) extends outside of the housing and that the housing is in contact with the chamber via a junction comprising a separating gate (23) between the chamber and the housing, the gate capable of being opened, and a flexible, sealed portion (35) separating the chamber from the housing.

2. Microscope device according to claim 1, **characterised in that** the flexible portion of the junction is a bellows.

3. Microscope device according to claim 1 or 2, **characterised in that** the flexible portion of the junction is connected to an interface (21) on the side nearest the chamber (22), which is assembled in a separable manner with an interface on the side nearest the housing.

4. A microscope device according to claim 3, **characterised in that** the gate (23) is comprised from two superimposed portions (24, 25) capable of being assembled with each other or separated, said gate portions (21, 22) being capable of respectively shutting off the interfaces.

5. Microscope device according to any one of claims 1 to 4, **characterised in that** the gate is removable and held by a peripheral seal (33) housed in the junction and protruding into an aperture of the junction.

6. Microscope device according to claim 5, **characterised in that** the peripheral seal is inflatable.

7. Microscope device according to claim 4, **characterised in that** a second peripheral seal (26) is compressed between the gate portions when the latter are assembled together.

8. Microscope device according to claim 4 or 7, **characterised in that** the gate portions are assembled via correlating pins (27) and locks (28).

9. Microscope device according to claim 8, **characterised in that** the locks are dual effect locks and also hold one of the gate portions (24) in the interface (21) on the side nearest the chamber.

10. Microscope device according to any one of the previous claims, **characterised in that** the microscope (16) and the housing (6) are mounted on separate supports (15, 17), and the housing (6) is mounted on its support by shock-absorbing stops (14).

11. Microscope device according to any one of the previous claims, **characterised in that** the housing (6) forms an elbow partially covering the microscope compartment, and comprises a side flange (7) with an anterior surface through which the samples are inserted and removed from and to an external environment and a posterior flange (8) comprising the junction to the chamber.

12. Microscope device according to claim 11, **characterised in that** it comprises an external protection casing (19; 40, 41) opening at will in front of the anterior surface of the housing and in front of the microscope (16).
